# EUROPEAN PATENT APPLICATION

(11) **EP 2 620 985 A1**
(43) Date of publication of application: **31.07.2013**
(21) Application number: 11826829.1
(22) Date of filing: 20.09.2011
(51) Int. Cl.: H01L 31/04, C08G 73/10

(54) **POLYIMIDE RESIN COMPOSITION FOR USE IN FORMING INSULATION FILM IN PHOTOVOLTAIC CELL AND METHOD OF FORMING INSULATION FILM IN PHOTOVOLTAIC CELL USED THEREWITH**

(30) Priority: 21.09.2010 JP 2010211192
(71) Applicant: PI R & D Co. Ltd, Kanwasaki-shi Kanagawa 210-0855 (JP)
(72) Inventor: WIN Maw Soe, Yokohama-shi Kanagawa 236-0002 (JP); GOSHIMA, Toshiyuki, Yokohama-shi Kanagawa 236-0002 (JP); SATO, Takahiro, Yokohama-shi Kanagawa 236-0002 (JP)
(74) Representative: Stuart, Ian Alexander
(86) International application number: PCT/JP2011/071350
(87) International publication number: WO 2012/039384

(57) **Abstract**

Disclosed is a polyimide resin composition for forming an insulation layer in a solar cell, which has an optimal rheological characteristics for screen printing and the like, which has an improved wetting property with various coating substrates, by which continuous printing of 500 times or more can be attained, with which blisters, cissing and pinholes are not generated after printing and drying or during drying or curing, which can coat a predetermined area. A method of forming an insulation layer in a solar cell and a solar cell having the insulation layer formed by this method are also disclosed. The polyimide resin composition for forming an insulation layer in a solar cell contains a mixed solvent of a first organic solvent (A) and a second organic solvent (B); and a heat-resistant polyimide resin having at least one group selected from the group consisting of alkyl groups and perfluoroalkyl groups in recurring units, and having thixotropic property, the polyimide resin being dissolved in the mixed solvent.

## Description

### Technical Field

The present invention relates to a polyimide resin composition for forming an insulation film in a solar cell, a method of forming an insulation film in a solar cell using the same, and a solar cell formed by the method.

### Background Art

In recent years, the developments of clean energies are demanded because of the depletion of energy resources, global environmental problem such as increase in carbon dioxide in the atmosphere and the like. Solar cells converting sun light to electric energy directly are widely used, and the development thereof is now proceeding to attain more advanced functions. Therefore, in particular, photovoltaic generation using solar cells has been developed, and practically used as a new energy source, and is making further progress.

The solar cells are well-known devices for converting solar radiation to electrical energy. The major solar cells are ones produced, for example, by diffusing impurities having opposite conductivity type to that of a silicon substrate on a light-receiving surface of the silicon substrate composed of single crystals or polycrystals to form a pn junction, and by forming electrodes on the light-receiving surface and on the back side opposite thereto of the silicon substrate respectively. Further, thinning of the silicon substrate is proceeding for reducing the cost of raw materials. With thinning of solar cells (hereinafter referred to as simply "cells"), cell cracks caused by wiring operation during manufacturing of solar cell modules (hereinafter referred to as simply "modules") are problematic, and a method of wiring by using circuit boards with back electrode type solar cells has been proposed to solve this problem.

The solar cells can be produced on a semiconductor wafer using semiconductor processing technique. Generally speaking, p-type regions and n-type regions can be formed in one silicon substrate to produce solar cells. Each adjacent p-type region and n-type region can form a pn junction. Solar radiation impinging on the solar cells creates electrons and holes, and the electrons and holes migrate to the p-type and n-type regions, thereby creating voltage differentials across the p-n junctions. In a backside contact solar cell, the p-type and n-type regions are connected to metal contacts on the backside of the solar cell to allow an external electrical circuit or device to be connected to and be powered by the solar cell.

In recent years, with the compaction, thinning and high integration of solar cells, insulation and protection of small areas became necessary and formation of protective layers and the like having a precise pattern is demanded. That is, formation of layers became necessary which give protection from α-ray and external stresses such as the pressure applied during resin molding, which became great enemy of semiconductor devices because of the increased precision of the semiconductor devices.

In the conventional production techniques, a method of forming a protective layer in a solar cell in which a polyamic acid or a polyimide resin varnish for protective layers is applied by spin coating method to form a thin film has been used in practice. However, this method has a problem in that it cannot form a thin layer only on the necessary area. Therefore, an additional step for forming a desired pattern, such as photolithography is necessary, which is complicated.

Still further, in most cases, the polyimide resin used for forming the polyimide layer is in the form of a polyamic acid. To convert the polyamic acid to polyimide, a step of heating the applied thin film to ring-close (imidize) the polyamic acid (350-500°C) is necessary. As a result, the method has a problem in the processability, such as the shrinkage of the resin during the imidization reaction is large, so that it is difficult to form a resin protective layer with a precise pattern particularly on a semiconductor wafer or the like.

A method of forming a resin pattern by exposure with light using a photosensitive polyimide resin has also been proposed. However, this method has a problem in that the photosensitizing material is limited and expensive, and the method may not be used in wet system. Further, in many cases, in solar cell elements, the outgas components attach to the metal layers which are to be connected to electrodes. As a result, there is a concern that the reliability of the product may be reduced, so that the photosensitizing material cannot be used.

The electrodes and insulation layer can be formed very simply by applying electrically conducting materials with the prescribed printing method in at least any one of the step of forming a first electrode provided at the backside of the solar cell and the step of forming a second electrode, and by applying insulating materials with the prescribed printing method to form the insulation layer, when compared with the method using photolithography and vacuum process. By this, mass production can be achieved easily and production cost can be reduced.

The prescribed printing method in the step of forming the insulation layer is desired to be any one of screen printing, offset printing and ink jet printing. In order to assure the insulation property of the insulation layer, the step of forming the insulation layer preferably include the step of heating the applied insulating material, or the step of irradiating with ultraviolet light to cure them after applying the insulating material. The heating temperature in the heating step is preferably 150°C to 600°C. When the heating temperature is less than 150°C, the solvent contained in the applied insulating material cannot be removed. On the other hand, the heating temperature is higher than 600°C, the insulation layer is cracked and the insulation property cannot be assured.

The insulating materials preferably contain at least any one of polyimides, polyimide precursors and polyamideimides. Recently, as the methods of forming images of polyimide resin films used as surface protective films, interlayer insulation films, stress buffers and the like, screen printing method and dispense method are attracting attention. These methods do not require complicated steps such as exposure, development, etching and the like, and films can be formed only on the necessary portions on wafers. As a result, a large cost saving can be attained. Patent Literatures 1 to 3 describe the structures of solar cells using polyimides and polyimide precursors for insulation layers, but specific examples of the polyimides and polyimide precursors are not described.

Patent Literatures 4 to 5 disclose, as a method of forming a protective film on the surface of a semiconductor wafer, a method of coating the surface of the wafer with a paste for printing by screen printing method. The paste is composed of a polyimide which is a base resin, an inorganic filler such as silica, and a solvent. The inorganic filler is added for giving thixotropic property, so as to prevent the sagging and bleeding during printing. However, when a large amount of the inorganic filler is added, there is a tendency that problems arise in that the film strength is decreased, adhesion with the substrate is decreased and the like. Further, since *N*-methyl-2-pyrrolidone (NMP) is used as the solvent, the paste and the screen are largely influenced. That is, due to moisture absorption by NMP, the viscosity of an NMP-containing paste changes and in a severe case, even the resin component is precipitated. Once the resin component precipitates, mesh of the screen is clogged, and when the viscosity change occurs, the printing conditions change with time, so that stable printing cannot be attained. As for the screen, since the resistance of the emulsion to NMP is low, dimensional change of the pattern and skipping and chipping of small pattern due to the swelling of the emulsion occur, which give bad influence on the products. These problems are more and more severe as the pattern is finer and finer. The above-described problems of NMP cannot be solved by decreasing the NMP content, and in many cases, even when the NMP content is considerably small, NMP gives influence. As a result, there is a tendency that the NMP-containing paste is a special paste which can be handled only by a skilled person who thoroughly knows the characteristics of the paste.

To solve the problems caused by the inorganic fillers, Patent Literatures 6 to 9 propose heat-resistant resin pastes by which polyimide patterns having excellent properties can be formed by composing the resin composition with a special organic filler which melts during heating and drying, which is dissolved in the base resin and forms the film together with the base resin (i.e., soluble filler), a base resin and a solvent. However, since the viscosity at 25°C is 100 to 10,000 Pa·s, which is relatively high, there is a problem in that the screen mesh is not easily detached from the wafer, so that continuous printing is difficult.

### Prior Art References

### Patent Literatures

Patent Literature 1: US 5,053,083
Patent Literature 2: US 4,927,770
Patent Literature 3: 2009-253096 A
Patent Literature 4: DE 4,013,435 A1
Patent Literature 5: DE 4,410,354 A1
Patent Literature 6: JP 2000-154346 A
Patent Literature 7: JP 2-289646 A
Patent Literature 8: JP 11-100517 A
Patent Literature 9: JP 11-106664 A
Patent Literature 10: WO 00/41884

### Disclosure of the Invention

### Problems to be Solved by the Invention

As a method to solve problem in reliability of solar cells in long-term use, a method using polyimides for insulation layer has been studied. The polyimides are preferred in that hydrolysis due to water absorption and thermal decomposition are not caused, and adhesion to SiO₂ and electrically-conductive materials is also excellent. An object of the present invention is to provide a polyimide resin composition for forming an insulation film in a solar cell, which has an optimal rheological characteristics for screen printing and dispense coating, which has an improved wetting property with various substrates to be coated (SiO₂, SiN, Si, Al, Au and the like), by which continuous printing of 500 times or more can be attained, with which blisters, cissing and pinholes are not generated after printing and drying or during drying or curing, and which can coat a predetermined area, as well as to provide a method of forming an insulation film in a solar cell using the same, and a solar cell comprising the insulation film formed by the method. Means for Solving the Problems

The present inventors intensively studied to discover that a polyimide resin which is soluble in a mixed solvent free from the problems of moisture absorption and evaporation during coating in screen printing method, ink jet method or dispense method can be obtained by appropriately designing the constitution of the polyimide; and that a composition containing this polyimide in the mixed solvent has an excellent rheological characteristics and excellent pattern-forming property, and does not cause a problem such as poor patterning even after various steps such as drying. Further, the present inventors disclose the improved structure of back electrode type solar cells using the above-mentioned polyimide resin for insulation layer, which can show higher efficiency than that of conventional solar cells, thereby completing the present invention.

That is, the present invention has the following constitutions.

(1) A polyimide resin composition for forming an insulation film in a solar cell, said composition comprising:
   a mixed solvent of a first organic solvent (A) and a second organic solvent (B); and
   a heat-resistant polyimide resin having at least one group selected from the group consisting of alkyl groups and perfluoroalkyl groups in recurring units, and having thixotropic property, said polyimide resin being dissolved in said mixed solvent.
(2) The composition according to (1), wherein each of said alkyl groups and perfluoroalkyl groups has 1 to 4 carbon atoms.
(3) The composition according to (1) or (2), wherein said polyimide resin comprises recurring units represented by the following formula [I]:

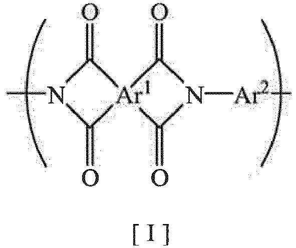

(wherein Ar¹ represents an arbitrary tetravalent organic group, Ar² represents an arbitrary divalent organic group, and at least either one of Ar¹ and Ar² have said alkyl group and/or perfluoroalkyl group).
(4) The composition according to (3), wherein said Ar¹ is represented by the following formula [II]:

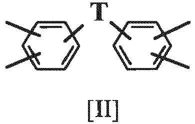

(wherein T represents -C(CH₃)₂- or -C(CF₃)₂-).
(5) The composition according to (3) or (4), wherein said Ar² is represented by the group selected from the group consisting of the following formula [III]:

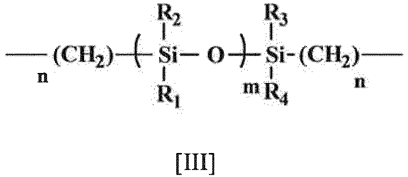

(wherein R₁, R₂, R₃ and R₄ independently represent one selected from the group consisting of hydrogen, a hydroxyl group, C₁-C₄ alkyl group, phenyl group, F, Cl and Br (wherein at least one of R₁, R₂, R₃ and R₄ represent a C₁-C₄ alkyl group), and n and m independently represent an integer of 1 to 10);
the following formula [IV]:

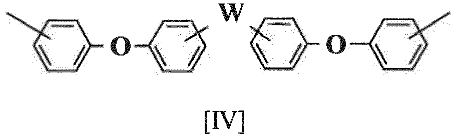

(wherein W represents -C(CH₃)₂- or -C(CF₃)₂-); and
the following formula [V]:

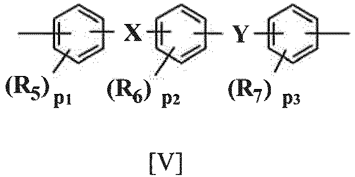

(wherein X and Y are independently selected from the group consisting of -C(=O)-, - SO₂-, -O- -S-, -(CH₂)ₐ- (a represents an integer of 1 to 5), -NHCO-, -C(CH₃)₂-, - C(CF₃)₂-, -C(=O)O- and a single bond; R₅, R₆ and R₇ are independently selected from the group consisting of hydrogen, a hydroxyl group, C₁-C₄ alkyl group, phenyl group, F, Cl and Br (wherein at least one of R₅, R₆, and R₇ represent a C₁-C₄ alkyl group), and p1, p2 and p3 independently represent an integer of 1 to 4).
(6) The composition according to any one of (1) to (5), wherein said polyimide resin contains 1,3-bis(3-aminopropyl)tetramethyldisiloxane in an amount of 0 to 20 mol% based on total diamine components, and has a glass transition temperature of 150°C or higher.
(7) The composition according to any one of (1) to (6), wherein said organic solvent (A) and said organic solvent (B) have different evaporation rates, and said polyimide has a lower solubility in the organic solvent having a smaller evaporation rate.
(8) The composition according to any one of (1) to (7), wherein said organic solvent (A) is a hydrophobic solvent and has a vapor pressure at room temperature of 1 mmHg or lower, and said organic solvent (B) is a hydrophilic solvent having a vapor pressure at room temperature of 1 mmHg or lower.
(9) The composition according to any one of (1) to (8), which has a viscosity of 20,000 to 200,000 mPa·s at a shear rate of from 1 to 100 s⁻¹.
(10) The composition according to any one of (1) to (9), which has a thixotropy coefficient of from 1.5 to 10.0.
(11) A method of forming an insulation film in a solar cell, said method comprising coating a base layer in said solar cell with said composition according to any one of (1) to (10), and drying the composition to form an insulation film composed of a polyimide film
(12) The method according to (11), wherein said polyimide film is formed by screen printing method, ink jet method or dispense method.
(13) The method according to (11) or (12), wherein a polyimide film having a thickness of 1 µm or more after drying is formed by one coating.
(14) The method according to any one of (11) to (13), the method comprising:
   the step of forming a first electrode by using an electrically-conductive material on a main surface of a crystalline silicon substrate composed of a single crystalline silicon or a polycrystalline silicon; and
   the step of coating the surface of the first electrode with an insulation film by printing method; and
   the step of forming a second electrode on the surface of the insulation film by using an electrically-conductive material such that the second electrode is electrically insulated from the first electrode.
(15) A solar cell comprising the insulation film formed by the method according to any one of (11) to (14).

### Effect of the Invention

The composition for forming an insulation film in a solar cell according to the present invention can be coated by screen printing method, inkjet method or dispense method, has excellent rheological characteristics, and has excellent wetting property with Si substrates and excellent pattern-forming property and continuous printing property. The coating films formed with the resin composition of the present invention can be used as insulation films in solar cells, which have excellent adhesion with Si substrates and electrically-conductive materials used for electrodes, and have excellent long-term electric properties, heat-resistance and chemical resistance.

### Brief Description of the Drawings

Fig. 1 is a schematic cross-sectional view of a preferred embodiment of a solar cell comprising an insulation film formed by the method of the present invention.
Fig. 2 is a schematic cross-sectional view of another preferred embodiment of a solar cell comprising an insulation film formed by the method of the present invention.

### Description of Symbols

- 1: Solar cell
- 2: Silicon substrate
- 3: P+ layer
- 4: N+ layer
- 5: Passivation film
- 6: Contact hole
- 7: Antireflection coating
- 8: P electrode contact
- 9: P electrode
- 10: N electrode
- 11: Insulation layer
- 12: External electric circuit
- 13: Insulation layer

### Mode for Carrying out the Invention

The polyimide contained in the polyimide resin composition of the present invention is one which can be obtained by dissolving a tetracarboxylic dianhydride(s) and a diamine(s) in an organic solvent, and carrying out direct imidization (i.e., without through a polyamic acid) in the presence of an acid catalyst. The polyimide can also be produced by reacting a tetracarboxylic dianhydride and a diamine in an organic solvent, and then adding at least one of a tetracarboxylic dianhydride and a diamine so as to carrying out imidization (the production process will be described later).

In cases where it is desired to promote the thixotropic property so as to attain a fine pattern printing by the addition of an inorganic filler, the amount of the added inorganic filler is inevitably increased. As a result, there arises a concern about the problem in adhesion with substrates. Thus, in designing the solvent-soluble polyimide, the fine pattern-forming property and adhesion should be taken into consideration. After intensive study, the present inventors discovered that if the polyimide has at least one of alkyl groups and perfluoroalkyl groups in the recurring units thereof, excellent fine pattern-forming property and adhesion are obtained, and the polyimide can be suitably used for attaining the object of the present invention.

In particular, the following polyimides are preferred in view of the above-mentioned effects.
That is, the polyimides comprising recurring units represented by the following formula [I] are preferred:

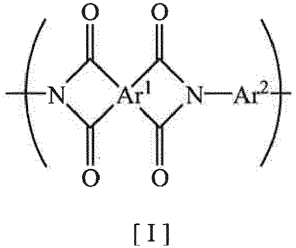

(wherein Ar¹ represents an arbitrary tetravalent organic group, Ar² represents an arbitrary divalent organic group, and at least either one of Ar¹ and Ar² have the alkyl group and/or perfluoroalkyl group).

Among the polyimides represented by the formula [I], polyimides having Ar¹ represented by the following formula [II] are especially preferred:

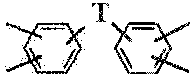

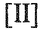

(wherein T represents -C(CH₃)₂- or -C(CF₃)₂-).

Further, polyimides having Ar² represented by any one of the following formulae [III] to [V] are preferred:

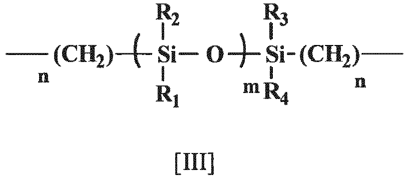

(wherein R₁, R₂, R₃ and R₄ independently represent one selected from the group consisting of hydrogen, a hydroxyl group, C₁-C₄ alkyl group, phenyl group, F, Cl and Br (wherein at least one of R₁, R₂, R₃ and R₄ represent a C₁-C₄ alkyl group), and n and m independently represent an integer of 1 to 10);

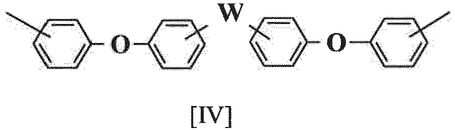

(wherein W represents -C(CH₃)₂- or -C(CF₃)₂-);

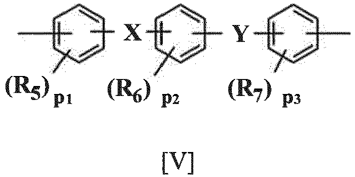

(wherein X and Y are independently selected from the group consisting of -C(=O)-, - SO₂-, -O-, -S-, -(CH₂)ₐ- (a represents an integer of 1 to 5), -NHCO-, -C(CH₃)₂-, - C(CF₃)₂-, -C(=O)O- and a single bond; and R₅, R₆ and R₇ are independently selected from the group consisting of hydrogen, a hydroxyl group, C₁-C₄ alkyl group, phenyl group, F, Cl and Br (wherein at least one of R₅, R₆, and R₇ represent a C₁-C₄ alkyl group), and p1, p2 and p3 independently represent an integer of 1 to 4).

Preferred examples of the tetracarboxylic dianhydride containing the structure represented by the above-described formula [II] include 2,2-bis (3,4-dicarboxyphenyl)propane dianhydride and 4,4'-(4,4'-isopropylidenediphenoxy)bisphthalic dianhydride, 2,2-bis (3,4-dicarboxyphenyl)hexafluoropropane dianhydride and 1,4-bis(3,4-dicarboxytrifluorophenoxy)tetrafluorobenzene dianhydride.

R₁ to R₄ in the formula [III] are C₁-C₁₀, preferably C₁-C₄ substituted or unsubstituted monovalent hydrocarbon group, and may be any of an aliphatic hydrocarbon group, alicyclic hydrocarbon group, and aromatic hydrocarbon group. Further, R₁ to R₄ may be the same or different. Specific examples of the R₁ to R₄ include an alkyl group such as methyl group, ethyl group, propyl group, isopropyl group, butyl group, iso-butyl group, tert-butyl group, pentyl group, hexyl group, heptyl group, octyl group; and an alkenyl group such as vinyl group, allyl group, propenyl group, isopropenyl group, butenyl group, isobutenyl group, hexenyl group and the like for an aliphatic hydrocarbon group. Examples of the alicyclic hydrocarbon group include a cycloalkyl group such as cyclohexyl group or cyclopentyl group; a cycloalkenyl group such as cyclohexenyl group and the like. Examples of the aromatic hydrocarbon group include an aryl group such as phenyl group, tolyl group or xylyl group; an aralkyl group such as benzyl group, ethyl phenyl group or propyl phenyl group, and the like. The R₁ to R₄ may be a C₁-C₄ alkoxy group, alkenoxy group or cycloalkyl group, and specific examples thereof include methoxy group, ethoxy group, propoxy group, isopropoxy group, butoxy group, isobutoxy group, tert- butoxy group, hexyloxy group, cyclohexyloxy group, octoxy group, vinyloxy group, allyloxy group, propenoxy group and isopropenoxy group. Among these, more preferred R₁ to R₄ are methyl group and phenyl group.

Preferred examples of the diamine containing the structure represented by the above-described formula [IV] include 2,2-bis[4-(4-aminophenoxy)phenyl]propane, 2,2-bis[4-(4-aminophenoxy)phenyl]hexafluoropropane, 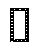 , 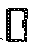 -bis[4-(4-aminophenoxy)phenyl]-1,3-diisopropylbenzene and 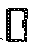 , 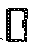 -bis[4-(4-aminophenoxy)phenyl]-1,4-diisopropylbenzene.

Preferred examples of the diamine containing the structure represented by the above-described formula [V] include α,α-bis(4-aminophenyl)-1,3-diisopropylbenzene, 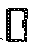 , 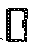 -bis(4-aminophenyl)-1,3-dihexafluoroisopropylidenebenzene, 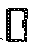 , 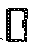 -bis(4-aminophenyl)-1,4-diisopropylbenzene and 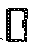 , 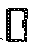 -bis(4-aminophenyl)-1,4-dihexafluoroisopropylidenebenzene.

As the tetracarboxylic dianhydride and diamine constituting the polyimide used in the present invention, in addition to the above-described at least one of tetracarboxylic dianhydrides and diamines containing at least one of alkyl groups and perfluoroalkyl groups, one or more of other tetracarboxylic dianhydrides and diamines are usually used in order to give various functions such as heat resistance, electric properties, physical properties of the film, adhesion and the like.

Examples of such tetracarboxylic dianhydride include pyromellitic dianhydride, 3,3',4,4'-biphenyltetracarboxylic dianhydride, bis(3,4-dicarboxyphenyl)ether dianhydride, 3,3',4,4'-benzophenone tetracarboxylic dianhydride, 3,3',4,4'-biphenylsulfone tetracarboxylic dianhydride and bicyclo [2.2.2]oct-7-ene-2,3,5,6-tetracarboxylic dianhydride. Among these tetracarboxylic dianhydrides, bis(3,4-dicarboxyphenyl)ether dianhydride and 3,3',4,4'-biphenylsulfone tetracarboxylic dianhydride can suitably be employed in view of the solubility. These tetracarboxylic dianhydrides may be used individually or two or more of them may be used in combination.

Examples of the diamines include 2,4-diaminotoluene, 4,4'-diamino-2,2'-dimethyl-1,1'-biphenyl, 4,4'-diamino-2,2'-ditrifluoromethyl-1,1'-biphenyl, 4,4'-diamino-3,3'-ditrifluoromethyl-1,1'-biphenyl, *m*-phenylenediaine,*p-*phenylenediamine, 4,4'-diamino-3,3'-dihydroxy-1,1'-biphenyl, 4,4'-diamino-3,3'-dimethyl-1,1'-biphenyl, 9,9'-bis(3-methyl-4-aminophenyl)fluorene and 3,7-diaminodimethyldibenzothiophene 5,5-dioxide, bis(3-carboxy-4-aminophenyl)methylene, 2,2-bis(3-hydroxy-4-aminophenyl)propane, 2,2-bis(4-aminophenyl)propane, 2,2-bis(3-methyl-4-aminophenyl)propane, 3,4'-diaminodiphenyl ether, 4,4'-diaminodiphenyl ether, 3,3'-diaminodiphenyl sulfone, 4,4'-diaminodiphenyl sulfone, 4,4'-diaminodiphenyl sulfide, 3,5-diaminobenzoic acid, 2,6-diaminopyridine, 4,4'-(hexafluoroisopropylidene)dianiline, 2,2-bis(3-amino-4-hydroxyphenyl)hexafluoropropane, 2,2-bis(3-amino-4-methylphenyl)hexafluoropropane, 4,4'-(9-fluolenylidene)dianiline, 1,3-bis(3-aminophenoxy)benzene, 1,3-bis(3-hydroxy-4-aminophenoxy)benzene, 1,3-bis(4-aminophenoxy)benzene, 1,4-bis(4-aminophenoxy)benzene, 2,2-bis(3-hydroxy-4-aminophenyl)benzene and 2,2-bis(3-methyl-4-aminophenyl)benzene. These diamines may be used individually or two or more of them may be used in combination.

The polyimide used in the present invention is usually obtained by using the above-described at least one of tetracarboxylic dianhydrides and diamines having at least one of alkyl groups and perfluoroalkyl groups, and at least one of the other tetracarboxylic dianhydrides and diamines described above in combination. Among the tetracarboxylic dianhydride components and diamine components constituting the polyimide, the percentage of the components having at least one of alkyl groups and perfluoroalkyl groups is usually from 10 mol% to 80 mol%, preferably 20 mol% to 60 mol%. If the percentage of the components having at least one of alkyl groups and perfluoroalkyl groups is within this range, excellent fine pattern-forming property and adhesion are obtained.

In cases where the substrate is a nitride film, there is a tendency that the adhesion between the aromatic polyimide and the substrate is poor. Therefore, it is preferred to use 1,3-bis(3-aminopropyl)tetramethyldisiloxane as one of the diamine components. This diamine is most preferred because it is commercially available from Shin-Etsu Chemical under the trade name PAM-E and from Toray Dow Coming under the trade name BY16-871. The added amount of this diamine is preferably from 1 mol% to 20 mol%, more preferably from 3 mol% to 15 mol% based on the total diamines. If the amount is more than 20 mol%, there is a tendency that the glass transition temperature of the polyimide resin is too low, and a problem may arise during the continuous operation of the semiconductor substrate at a high temperature.

To promote the chemical resistance, a reactive group may be introduced to the terminal(s) of the polyimide. For example, by adding the tetracarboxylic dianhydride in an amount slightly higher than the required amount, it is possible to make the terminals of the polyimide be the dianhydride. Thereafter, by adding an amine compound typified by 3-ethynylaniline or 4-ethynylaniline, acetyl groups can be introduced to the terminals of the polyimide. Similarly, reactive groups can be introduced by synthesizing the polyimide by adding the diamine compound in an amount slightly higher than the required amount to obtain a polyimide whose terminals are the diamine, and then adding an acid anhydride typified by maleic anhydride, ethynylphthalic anhydride or phenylethynylphthalic anhydride. These terminal groups are reacted under heat at a temperature of 150°C or higher so as to crosslink the polymer main chain.

The polyimide contained in the polyimide resin composition of the present invention can be produced by a known method in which the tetracarboxylic dianhydride and the diamine are dissolved in an organic solvent and they are directly imidized in the presence of an acid catalyst. The polyimide can also be produced by reacting the tetracarboxylic dianhydride with the diamine in the organic solvent, then adding at least one of a tetracarboxylic dianhydride and a diamine, and carrying out imidization. The mixing ratio of the tetracarboxylic dianhydride to the diamine is preferably such that the total amount of the diamines is 0.9 to 1.1 mol per 1 mol of the total amount of the tetracarboxylic dianhydrides. As the acid catalyst, a catalyst such as acetic anhydride/triethylamine system, valerolactone/pyridine system or the like for chemical imidization may preferably be employed. The reaction temperature is preferably from 80°C to 250°C, and the reaction time can be appropriately selected depending on the scale of the batch and the reaction conditions employed. Further, block polyimide copolymers obtained by dividing the imidization reaction into two or more steps, and reacting different tetracarboxylic dianhydrides and/or diamines in the respective steps, may preferably be employed. The production processes *per se* of the solvent-soluble block polyimide copolymers are known as described in, for example, Patent Literature 10, and the polyimide suitably used in the present invention can be synthesized by a known method using the above-described tetracarboxylic dianhydride(s) and/or diamine(s).

The number average molecular weight of the thus obtained polyimide resin is preferably 6,000 to 60,000, more preferably 7,000 to 40,000. If the number average molecular weight is less than 6,000, the physical properties of the film such as breaking strength are tend to be degraded, and if it is more than 60,000, the viscosity is high and so the problem of cobwebbing arises, so that it is difficult to obtain a varnish suited for printing and coating. The number average molecular weight herein means the one in terms of polystyrene based on the calibration curve prepared with a gel permeation chromatography (GPC) apparatus using standard polystyrenes.

The solvent contained in the composition of the present invention is a mixed solvent of a first organic solvent (A) and a second organic solvent (B). It is most preferred that the solvents have different evaporation rates, and the solubility of the polyimide in the solvent having a lower evaporation rate is lower than in the solvent having a higher evaporation rate. If these are satisfied, the sagging of the pattern during drying can be avoided, and so the pattern immediately after the coating can be retained. Since the solubilities in various solvents differ depending on the composition of the polyimide, it is not restricted whether the organic solvent (A) or organic solvent (B) has a higher evaporation rate. The evaporation rate of the solvents can be measured by using a commercially available differential thermogravimetric simultaneous analyzer and measuring the weight loss. In the Examples below, the evaporation rate is measured by using TG-DTA 2000S commercially available from MAC. Science Co., Ltd., under the conditions of: N₂ flow rate: 150 ml/min; temperature: 40°C, sample amount: 20 µL; the sample is dropped onto a cup having an opening with a diameter of 5 mm.

The first organic solvent (A) is preferably a hydrophobic solvent (that is, a solvent practically insoluble in water), and preferably is a solvent having a vapor pressure at room temperature of 1 mmHg or lower. Specific examples of the first organic solvent (A) include benzoic acid esters such as methyl benzoate and ethyl benzoate; acetic acid esters such as benzyl acetate, butyl carbitol acetate; and ethers such as diethyleneglycol dibutyl ether. By using a solvent practically insoluble in water, whitening (precipitation phenomenon of polyimide) and viscosity change due to moisture absorption hardly occur especially in the screen printing. Further, if the vapor pressure at room temperature is higher than 1 mm Hg, the screen tends to be dried in the screen printing, so that the continuous printing property tends to be degraded.

The second organic solvent (B) is preferably a hydrophilic solvent (that is, a solvent miscible with water), and preferably is a solvent having a vapor pressure at room temperature of 1 mmHg or lower. Specific examples of the second organic solvent (B) include acetic acid esters such as diethylene glycol monoethyl ether acetate; glymes such as triglyme and tetraglyme; ethers such as tripropylene glycol dimethyl ether and diethylene glycol diethyl ether; and sulfolane. The term "miscible with water" is used for clearly indicating that a solvent having a vapor pressure and properties different from those of the first organic solvent (A) is used, and the second solvent (B) is not necessarily mixed with water. However, since good solvent varies depending on the various starting materials and the composition of the synthesized polyimide, the solvent to be combined with the practically water-insoluble organic solvent (A) is preferably a water-miscible solvent because the freedom of selection is larger. The reason why the vapor pressure of the organic solvent (B) at room temperature is 1 mmHg or lower is the same as described above for the organic solvent (A).

The mixing ratio of the first organic solvent (A) to the second organic solvent (B) is preferably such that the percentage of the first organic solvent (A) is from 30% by weight to 80% by weight based on the whole mixed solvent. If the percentage of the first organic solvent (A) is less than 30% by weight, the hydrophobicity of the solvent is not sufficient, so that whitening and viscosity change during the screen printing tend to occur.

To control the evaporation rate or to adjust the viscosity during the preparation of the resin composition, a diluent may also be used. Examples of the diluent include lactone solvents such as γ-butyrolactone; ketone solvents such as cyclohexanone; carbonate solvents such as ethylene carbonate and propylene carbonate. Using a diluent is effective especially in cases where the pattern to be formed is sufficiently large or the continuous printing property need not be so high, because the solubility of the polyimide is increased and the storage stability is improved. The most recommended solvent is γ-butyrolactone, and this solvent may also be used in the synthesis of the polyimide.

The content of the polyimide resin solid in the composition of the present invention is preferably from 15% to 60% by weight, more preferably from 25% to 50% by weight. If the solid content is less than 15% by weight, the thickness of the film which can be formed by the printing and coating in one time is small, so that two or more times of printing and coating tend to be required. If the solid content is more than 60% by weight, the viscosity of the resin composition tends to be too high.

As described later, the resin composition of the present invention has a thixotropic property. Since the thixotropic property can be given by adding an inorganic filler, it is effective to add an inorganic filler to the resin composition of the present invention. Examples of the inorganic filler for giving thixotropic property include at least one of silica, alumina and titania. More specifically, examples of the inorganic filler include at least one of amorphous silica with a size of 0.01 µm to 0.03 µm and spherical silica, alumina and titania with a diameter of 0.1 µm to 0.3 µm. To promote storage stability and the like, it is preferred to use an inorganic filler treated with a trimethylsilylating agent. The content of the inorganic filler in the composition is usually 0% to 50% by weight, preferably 2% to 30% by weight. If the content of the inorganic filler is within this range, appropriate thixotropic property is imparted.

Additives such as a coloring agent, antifoaming agent, leveling agent, adhesion-promoting agent and the like may be added to the polyimide resin composition of the present invention as long as the product is not adversely affected. Examples of the coloring agent include phthalocyanine blue, phthalocyanine green, iodine green, disazo yellow, crystal violet, titanium oxide, carbon black and naphthalene black. Antifoaming agents are used for extinguishing the foams generated in the printing, coating and curing steps. As the antifoaming agent, surfactants such as acrylic surfactants and silicone surfactants may be employed. Examples of the antifoaming agent include YK-A501 of BYK Chemi; DC-1400 of Dow Coming; and silicone antifoaming agents such as SAG-30, FZ-328, FZ-2191 and FZ-5609 of Nippon Unicar Co., Ltd. Leveling agents are used for eliminating the irregularities on the surface of the coating layer, which irregularities are formed during the printing and coating. More particularly, a surfactant in an amount of about 100 ppm to about 2% by weight is preferably added. By adding an acrylic, silicone or the like leveling agent, generation of foams can be reduced and the coating layer can be smoothened. Preferred leveling agents are anionic one not containing ionic impurities. Appropriate examples of the surfactant include FC-430 of 3M; BYK-051 of BYK Chemi; and Y-5187, A-1310 and SS-2801 to 2805 of Nippon Unicar Co., Ltd. Examples of the adhesion-promoting agent include imidazole compounds, thiazole compounds, triazole compounds, organic aluminum compounds, organic titanium compounds and silane coupling agents. The additives described above are preferably contained in an amount of 10 parts by weight or less based on 100 parts by weight of the polyimide resin component. If the amount of the above-described additives is more than 10 parts by weight, the physical properties of the obtained film tend to be degraded, and a problem of the pollution by the volatile components arises. Therefore, it is most preferred not to add the above-described additives.

The viscosity at 25°C of the polyimide resin composition of the present invention is preferably 3,500 to 30,000 mPa·s, more preferably 4,000 to 20,000 mPa·s, still more preferably 6,000 to 18,000 mPa·s. If the viscosity is less than 3,500 mPa·s, sagging or the like is likely to occur, and a sufficient film thickness and resolution cannot be obtained. If the viscosity is higher than 40,000 mPa·s, transferring property and ease of handling in printing tend to be degraded. The value of the viscosity is expressed in terms of apparent viscosity measured by using a rheometer at a revolution of 333 rad/s.

The value of the viscosity is important for not only retaining the shape of the coating layer immediately after coating, but also for the flowability, that is, the property to be easily deformed and flowed by the squeegee during the screen printing. In the screen printing, if the viscosity is high, the rolling of the resin composition may be hindered, so that the coating with a scraper may be insufficient and irregularities in coating and deformation tend to easily occur.

If an ink does not have a shape-retaining property to retain the shape of the coating layer immediately after coating in a desired pattern by the screen printing or the like, blur and sagging occur in the circumference of the pattern occurs, so that a thick film cannot be formed with a high resolution. By simply increasing the viscosity, although the sagging or the like can be inhibited, the problem in the detachment from the screen in the screen printing and problem in the irregularities in the coating film arise. Thus, to prevent the generation of blur and sagging, thixotropy coefficient is important. Although the thixotropic property can be quantified and evaluated from the obtained area of a hysteresis curve measured by a rheometer (measurement of the revolution dependence of the viscosity), it is simplest to evaluate the thixotropic property by the TI value measured by an ordinary viscometer. In the present invention, the thixotropy coefficient is expressed by η33/η333 which is a ratio of apparent viscosity (η33) of the resin composition at a shear rate of 33 (rad/s) to the apparent viscosity (η333) at 333 (rad/s).

The resin varnish preferably has a complex viscosity measured at a frequency of 33 rad/s of from 14,000 to 120,000 mPa·s. If the complex viscosity is higher than 120,000 mPa·s, the paste may remain in the mesh of the screen after the screen printing, and the detachment from the screen tends to be bad.

Therefore, it is preferred to adjust the thixotropy coefficient (η33/η333) at 25°C of the polyimide resin composition of the present invention within the range from 1.5 to 4.0, more preferably from 1.8 to 3.5, still more preferably from 2.5 to 3.2. If the thixotropy coefficient is 1.5 or more, sufficient resolution may easily be obtained in the screen printing. On the other hand, if the thixotropy coefficient is 4.0 or lower, the ease of handling during printing is promoted.

The polyimide resin composition of the present invention preferably has a good wetting property to silicon wafers, ceramic substrates, glass substrates, glass epoxy substrates, metal substrates typified by Ni, Cu and Al substrates and PI coating substrates. That is, any of the contact angles at room temperature on the surface of any of silicon, SiO₂ film, polyimide resin, ceramic and metal is preferably 20° to 90°. If the contact angle is 90° or less, a uniform coating film free from blisters, cissing and pinholes can be obtained. If the contact angle is more than 90°, the resin paste is repelled on the substrate, so that pinholes and defective patterning may occur. On the other hand, if the contact angle is less than 20°, sagging may occur during the leveling after coating, so that the precision of the patterning tends to be degraded, which is not preferred. The contact angle is defined as the angle between the tangent line and the substrate, which tangent line is drawn from the contact point when a drop of the heat-resistant resin paste is dropped on the substrate. The term "room temperature" mainly indicate a temperature of about 25°C. The contact angle of the composition can be adjusted by one or more of the composition of the polyimide resin, solvent, surfactant, antifoaming agent and leveling agent.

The insulation film in a solar cell can be formed by coating a base layer in a solar cell with the polyimide composition of the present invention, and drying the composition. As the coating method of the polyimide resin composition of the present invention, screen printing method, dispense method and ink jet method are preferred. Among these, screen printing method is most preferred because a large area can be coated in a short time. It is possible to form a film stably having a thickness of 1 µm or more, preferably 2 µm or more, after drying by one coating.
In view of the reliability of insulation, it is preferred to attain a film thickness of at least 5 µm by one coating. Therefore, in screen printing method, it is preferred to carry out the screen printing using a mesh screen having a line diameter of 50 µm or less and a mesh size of not smaller than 420 mesh, and using a squeegee made of a resin having a rubber hardness of not less than 70° and not more than 90°. The specification of the screen such as mesh diameter and number of mesh may appropriately be selected depending on the desired thickness of the film and pattern size. By the dispense method, thin line can be drawn, and the line thickness after allowing the wet coating film to stand at room temperature for one day can be made within the range of ±20% from the line thickness immediately after coating. Further, by the ink jet method, thin line can be drawn, and the line thickness after allowing the wet coating film to stand at room temperature for one day can be made within the range of ±100% from the line thickness immediately after coating.

By performing leveling, vacuum drying and the final curing steps on the polyimide resin composition after printing, insulation films and protective films having excellent electric properties, heat resistance and chemical resistance can be obtained. The leveling is performed preferably for 10 minutes or more. Although the vacuum drying is preferably performed because good finishing of the coating film can be attained, in cases where a leveling agent or an antifoaming agent is added, vacuum drying may not be necessary. The curing temperature and time of the final curing step may be appropriately selected depending on the solvent of the polyimide resin composition and the thickness of the coated film.

### Examples

The present invention will now be described concretely by way of Examples, but the present invention is not restricted to these Examples.

### 1. Syntheses of Polyimides

### Synthesis Example 1

To a 2L three-necked separable flask attached with a stainless steel anchor agitator, a ball condenser equipped with a water separation trap was attached. To the flask, 148.91 g (480 mmol) of bis-(3,4-dicarboxyphenyl)ether dianhydride (ODPA), 23.86g (96 mmol) of 1,3-bis (3-aminopropyl)tetramethyldisiloxane (PAM-E), 70.28g (204 mmol) of 4,4-(1,3-phenylenediisopropylidene)bisaniline (Bisaniline-M), 73.89 g (180 mmol) of 2,2-bis [4-(4-aminophenoxy)phenyl)propane (BAPP), 4.8 g of 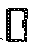 -valerolactone, 7.6 g of pyridine, 385 g of methyl benzoate (BAME), 385 g of tetraglyme and 100 g of toluene were added. After stirring the mixture at room temperature under a nitrogen atmosphere at 180 rpm for 30 minutes, the mixture was heated to 180°C and stirred at this temperature for 5 hours. During the reaction, toluene-water azeotrope was removed. By removing the refluxed materials, a polyimide solution with a concentration of 28% by weight was obtained.

### Synthesis Example 2

The same apparatus as used in Synthesis Example 1 was used. To the flask, 148.91 g (480 mmol) of ODPA, 29.82 g (120 mmol) of PAM-E, 74.41 g (216 mmol) of Bisaniline-M, 59.11 g (144 mmol) of BAPP, 4.8 g of 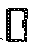 -valerolactone, 7.6 g of pyridine, 303 g of ethyl benzoate (BAEE), 455 g of tetraglyme and 100 g of toluene were added. After stirring the mixture at room temperature under a nitrogen atmosphere at 180 rpm for 30 minutes, the mixture was heated to 180°C and stirred at this temperature for 5 hours. During the reaction, toluene-water azeotrope was removed. By removing the refluxed materials, a polyimide solution with a concentration of 28% by weight was obtained

### Synthesis Example 3

The same apparatus as used in Synthesis Example 1 was used. To the flask, 71.66 g (200 mmol) of 3,3',4,4'-biphenylsulfone tetracarboxylic dianhydride (DSDA), 24.85 g (100 mmol) of PAM-E, 65 g of BAME, 98 g of tetraglyme, 4.0 g of γ-valerolactone, 6.3 g of pyridine and 50 g of toluene were added. After stirring the mixture at room temperature under a nitrogen atmosphere at 180 rpm for 30 minutes, the mixture was heated to 180°C and stirred at this temperature for 1 hour. During the reaction, toluene-water azeotrope was removed. The mixture was then cooled to room temperature, and 71.66 g (200 mmol) of DSDA, 48.04 g (150 mmol) of 4,4'-diamino-2,2'-ditrifluoromethyl-1,1'-biphenyl (TFMB), 61.58 g (150 mmol) of BAPP, 130g of BAME, 196 g of tetraglyme and 50 g of toluene were added. The mixture was allowed to react for 4 hours at 180°C with stirring at 180 rpm. By removing the refluxed materials, a polyimide solution with a concentration of 35% by weight was obtained.

### 2. Preparation of Polyimide Ink Compositions

Compositions containing each one of the polyimides obtained as described above, respectively, were prepared. To 50 g of the copolymer polyimide solution (the solution of Synthesis Examples 1 to 3 (28% by weight)) (the weight of the copolymer polyimide resin component is 14 g), titanium oxide (SJR-600M produced by Tayca Corporation) was added (15% by weight based on polyimide resin), and methyl (ethyl) benzoate as the organic solvent (A) and tetraglyme as the organic solvent (B) were added thereto. The vapor pressures of the organic solvent (A) and the organic solvent (B) at room temperature are 0.38 mmHg (25°C) and 0.01 mmHg or lower (20°C), respectively. The evaporation rates are 2256.3 mg/min/m² and 71.6 mg/min/m², respectively. The solubilities of the polyimides used in the present invention were larger in the organic solvent (A) than in the organic solvent (B). Thus, the solubility of the polyimide is lower in the solvent having a lower evaporation rate, which is preferred. As for the kneading method, TK Hivis Disper Mix 3D-5 type manufactured by Tokushu Kika Kogyo was used to carry out the kneading. With respect to 100 part of the polyimide resin, 40 part of titanium oxide, 19.3 part of methyl benzoate and 23.6 part of tetraglyme were used. The specific compositions of the prepared compositions are described below.

**[Table 1]**

| Example | Varnish Synthesis Example | Polyimide solids concentration (%) | SJR-600M (TiO₂) (part) | Methyl (ethyl) benzoate (part) | Tetraglyme (part) |
|---|---|---|---|---|---|
| 1 | 1 | 28 | 40 | 19.3 | 23.6 |
| 2 | 2 | 28 | 40 | 12.8 | 30.0 |
| 3 | 3 | 28 | 40 | 17.1 | 25.7 |

### 3. Film Formation

Films were formed on substrates using the above-described compositions, respectively. The substrate was a silicon wafer and each composition was applied by screen printing method. As for the specific coating conditions, the printing was performed using polyester mesh #420 and a squeegee having a hardness of 80°, at an attack angle of 70 °, with a clearance of 2.5 mm, under a printing pressure of 0.15 MPa at a printing rate of 260 mm/sec. Each coating film was dried to form a polyimide film. The drying was performed by conducting leveling for 10 minutes, heating under a nitrogen atmosphere at 140°C for 10 minutes, and then at 250°C for 30 minutes under the same atmosphere. The film thickness after drying was 5 µm.

### 4. Evaluation

The properties of the above-described polyimides, compositions and formed films were evaluated. The evaluations were carried out as follows:

### (a) Molecular Weight

The number average molecular weight Mn of the modified polyimide resin was measured by gel permeation chromatography (GPC) using HLC-8220GPC (commercially available from Tosoh Corporation). As the column, TSKgel GMH_{HR}-H commercially available from Tosoh Corporation was used. As the carrier solvent, LiBr solution in DMF at a concentration of 0.1N was used. The molecular weight is one calculated using standard polystyrenes (TSK standard polystyrenes).

### (b) Thermal Properties

Thermal decomposition initiation temperature of the polyimide resin was measured by DuPont 951 thermogravimetry apparatus.

### (c) Mechanical Properties

Mechanical properties of the polyimide resin were measured as follows: That is, a copper foil F2-WS (18 µm) commercially available from Furukawa Circuit Foil Co., Ltd. was coated with the polyimide composition by screen printing, to a thickness after drying of 15 ± 2 µm, and the thus obtained thin film was heated at 120°C for 10 minutes and then at 180°C for 30 minutes, thereby attaining drying and heat treatment, followed by removal of the copper foil by etching. The thus obtained polyimide resin film was measured for breaking strength, tensile elongation and initial elastic modulus by a universal tensile tester (Tensilon UTM-11-20, commercially available from Orientec).

(d) Viscosity and thixotropy coefficient were measured using Rheometer RS300 commercially available from Thermo Haake. More particularly, the measurements were carried out as follows: That is, after adjusting the temperature of a plate (stationary part) to 25 ± 0.1°C, a sample in an amount of 1.0 g to 2.0 g was placed thereon. A cone (movable part) was moved to a prescribed position and the resin solution was held until the temperature thereof reached 25 ± 0.1°C, under the condition such that the resin solution was sandwiched between the plate and the cone. Then the cone was started to revolute, and the revolution rate was gradually increased such that the shear rate reached to 33 rad/s in 10 seconds. This revolution velocity was kept and the viscosity after one minute was read. The revolution rate was further increased such that the shear rate reached 333 rad/s from 33 rad/s in 10 seconds, and the viscosity at 333 rad/s was read. The thus obtained value at the 33 rad/s was defined as the viscosity, and the ratio of the value at 323 rad/s was defined as the thixotropy coefficient.

(f) Printing property was evaluated by carrying out printing on the entire surface of a 6-inch silicon wafer using a printer LS-34TVA commercially available from Newlong Seimitsu Kogyo Co., Ltd. and L-Screen, Screen Polyester Mesh #420-27 commercially available from NBC Inc., and the number of cissing was counted by visual observation.

(g) Continuous printing property was evaluated as follows: Printing was performed using the apparatuses used in (f) described above. After carrying out the printing three times, the printing was stopped for 20 minutes. The printing was started again and the compositions with which the film thickness reached to the same thickness as that obtained before stopping within three times were evaluated as good (expressed as "○" in Table 1).

(h) Adhesion with the substrate was evaluated by the cross cut method according to JIS K5600-5-6.

**[Table 2]**

| Items | | Unit | Example 1 | Example 2 | Example 3 |
|---|---|---|---|---|---|
| Molecular weight | | Mn | 51000 | 53000 | 55000 |
| Glass transition temperature (Tg) | | °C | 172.5 | 167 | 219 |
| Thermal decomposition temperature (Td5%) | | °C | 493.5 | 508 | 469 |
| Breaking strength | | MPa | 70 | 75 | 107 |
| Tensile elongation | | % | 14.0 | 9.1 | 12.2 |
| Elastic modulus | | GPa | 2.24 | 2.4 | 2.6 |
| Viscosity | | mPa·s | 24000 | 32000 | 53000 |
| Thixotropic coefficient | | - | 2.2 | 3.2 | 3.6 |
| Printing property | Cissing | - | ○ | ○ | ○ |
| Continuous printing property | | - | ○ | ○ | ○ |
| Adhesion (to SiO₂) | | - | ○ | ○ | ○ |
| Adhesion (to SiN) | | - | ○ | ○ | ○ |

Embodiments of the application of the polyimide resin composition of the present invention to the film formation in solar cells will now be described.

### Production of Solar Cells

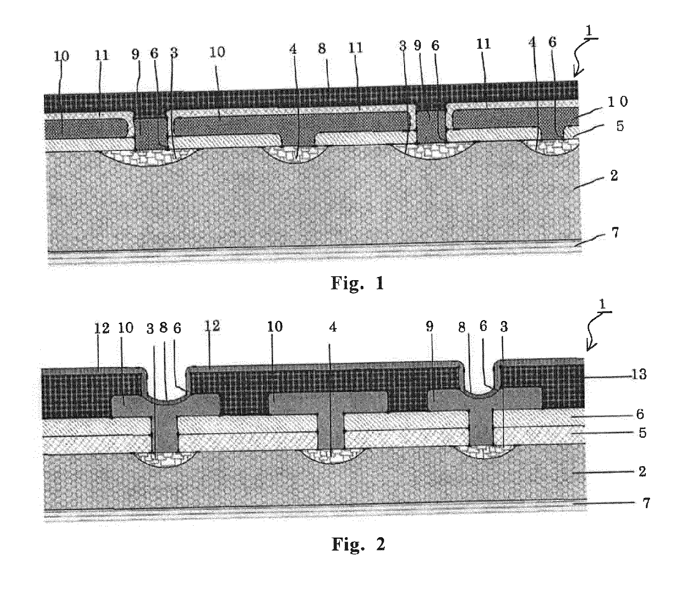

The production methods of solar cells and solar cell modules will now be concretely described as Examples based on Fig. 1. Each step of producing solar cells is well known and usual production step of solar cells.

### Example 4 (Solar Cell)

Firstly, P+ layer 3 and N+ layer 4 were formed at the back side of a silicon substrate, the back side was covered with a passivation film 5, and an antireflection coating 7 was formed on a light-receiving surface to prepare a solar cell. The silicon substrate 2 had a length of a side of 125 mm. The P+ layer 3 and N+ layer 4 were formed alternately in the form of a line at the back side of the silicon substrate 2, and a silicon oxide film was formed by thermal oxidation as a passivation film 5. A silicon nitride film was formed as an antireflection coating 7 by plasma CVD method

Then, contact holes 6 having a diameter of 0.1 mm were formed at intervals of every 0.3 mm at the parts of the passivation film 5, which parts were located directly on each of the P+ layers 3 and N+ layers 4. Contact holes 6 were formed by screen-printing a paste containing phosphoric acid as a main component and heating the printed paste.

Next, the N electrode 10 and the P electrode contact 8 were formed. The P electrode contacts 8 were formed inside the contact holes 6, and N electrodes 10 were formed in the form having intervals of about 0.1 mm between the N electrode 10 and the P electrode contact 8, by carrying out each pattern printing of silver pastes by screen printing and calcining the printed paste. As the silver paste, one composed of silver as a main component, a glass frit in an amount of several %, organic solvent for adjusting viscosity and thickener was used. The glass frit functions to acquire good contact property with the silicon substrate 2. As for the condition for calcining the silver paste, the peak temperature was 600°C and the heating was carried out at 500°C or more for 35 seconds. The organic components in the silver paste were decomposed completely by this calcination.

Thereafter, the surfaces of the N electrodes 10 were coated with the polyimide compositions produced in the above-mentioned Examples by screen printing such that only parts of the N electrodes 10 and P electrode contacts 8 were exposed. Then, the polyimide compositions were heated at a temperature of 140°C for 10 minutes, and 250°C for about 30 minutes to form the insulation layer 11.

Next, a paste containing silver as a main component was printed by screen printing such that the paste did not contact with the exposed parts of the N electrodes 10, and the printed paste was calcined to form the P electrode 8. Here, in order not to break the insulation layer 11, the calcination was carried out under the condition of the peak temperature of 450°C and at 400°C or more for 30 seconds. In order to carry out the calcination at a lower temperature than that in the step shown in Fig. 4, a silver paste not containing a glass frit and containing only organic components except silver was used unlike the silver paste for forming the N electrode 10 and P electrode contact 8. By using such a silver paste, low electric resistivity can be attained even by using the calcination at a low temperature.

Then, solar cell modules were fabricated by using the thus produced solar cells, and the change in electric conversion efficiency after deterioration under each condition was studied. As a result, the change was less than 5%. Therefore, it was confirmed that the solar cells using the polyimide compositions obtained in the above-mentioned Examples have effects on long-term reliability and improved electric conversion efficiency.

### Example 5 (Solar Cell (Part 2))

Here, the production methods of solar cells and solar cell modules will now be described as Examples based on Fig. 2.

The solar cell 1 has a substrate in the form having a silicon and a plurality of diffusion regions 3 and 4. The diffusion regions 3 and 4 were formed on the silicon 2 or on a layer laminated on the silicon 2. The diffusion region 3 includes a P-type diffusion region, and the diffusion region 4 includes a N-type diffusion region. The solar cell of the present invention is a back-junction solar cell in which the diffusion regions 3 and 4 are located on the silicon at the backside opposite to the passivation layer 5. The front passivation layer 5 is formed on the diffusion regions. The passivation layer 5 is formed to a thickness of about 100 to 600 nm by atmospheric-pressure chemical vapor deposition (APCVD) and contains silicon dioxide. The passivation layer is used for the electric insulation between the diffusion regions and the metal contact fingers in a conductive layer laminated thereon. The insulation layers 11 made of polyimides obtained in the above-mentioned Examples 1 to 3 are formed on the passivation layer 5, thereby preventing the metal contact fingers having a polarity from short-circuiting electrically the diffusion regions having another polarity. The polyimide compositions obtained in the above-mentioned Examples 1 to 3 were used for the polyimide insulation layer 5, which prevents the metal contact fingers electrically connected to the N-type diffusion region 2 from electrically short-circuiting the P-type diffusion region 3. The polyimide compositions described in the above-mentioned Examples 1 to 3 were applied by screen printing method to a thickness of 5 µm, and heated at a temperature of 140°C for 10 minutes and 250°C for about 30 minutes to form the polyimide insulation layer 5. The size of the opening between the polyimide insulation layers 5 is 300±100 µm.

Thereafter, the parts of the passivation layer 4 were removed to form the contact regions 6 passing through the passivation layer 4. The contact regions 6 are formed by etching on the passivation layer 5 using an etchant with which the polyimide insulation layer 11 is not etched so much. For example, In case of the passivation layer 4 containing silicon dioxide and polyimide insulation layer 5, the contact region 6 was formed by wet etching on the exposed parts of the passivation layer 5 with buffered oxide etching process (BOE) using hydrofluoric acid as an etchant. A plurality of contact hole regions 6 were obtained at the opening between the polyimide insulation layers 11. The metal contact finger (P electrode) 9 is formed such that it passes through the P electrode contact region 8. The metal contact finger (P electrode) 9 and the metal contact finger (N electrode) 10 include a laminate of materials. The materials include an aluminum layer having a thickness of 100 nm, the aluminum layer is formed on a titanium-tungsten layer having a thickness of 50 nm, the titanium-tungsten layer is formed on a copper layer having a thickness of 300 µm, and the copper layer is formed on a tin layer having a thickness of 6 µm. In the solar cells of the present invention, some metal contact fingers (P electrode) 9 and metal contact fingers (N electrode) 10 are provided. The metal contact fingers (P electrode) 9 are electrically connected to the P-type diffusion region 3 through the P electrode contact region 8, and are P-type metal contact fingers. Similarly, the metal contact fingers (N electrode) 10 are electrically connected to the N-type diffusion regions through the contact regions, and are N-type metal contact fingers. The external electric circuit 12 is connected to the metal contact fingers, thereby obtaining electric power from the solar cells.

**[Table 3]**

| Properties | SiO₂ | Polyimide compositions of Examples 1 to 3 | SiO2+Polyimide compositions of Examples 1 to 3 |
|---|---|---|---|
| Flatness | ○ | ⊚ | ⊚ |
| Pinholes | observed | not observed | not observed |
| Moisture barrier | possible | possible | possible |
| Stress fatigue or solder fatigue under severe environment | possible | possible | possible |

**[Table 4]**

| Substrate | Process | Adhesion | Remarks |
|---|---|---|---|
| Back Arc + Polyimide* (PI) | bArc + PI print + Hardbake | 5B | Cross Hatch |
| Back Arc + Polyimide + Metal | bArc + iPrint + Hardbake + Seed | 5B | Cross Hatch |
| Back Arc + Polyimide + Metal | bArc + iPrint + Hardbake + Seed + SGA | 5B | Cross Hatch |

| | | | |
|---|---|---|---|
| *: Polyimide compositions described in Examples 1 to 3 were used ACL336: Autoclave 336 Hr: 85°C x 85% x 336 H, HF10: Humidity Freeze 10 Days, TC50: Thermal Cycle 50 H | | | |

**[Table 5]**

| Cell Example | Conditions | Changes in efficiency range (%) |
|---|---|---|
| 2 | ACL168: Autoclave 168 Hr: 85°C x 85 % x 168 H | -2.044% to -1.121% |
| 2 | ACL336: Autoclave 336 Hr: 85°C x 85% x 336 H | -3.073% to -0.866% |
| 2 | TC50: Thermal Cycle 50 H | -1.198% to 1.7154% |
| 2 | TC200: Thermal Cycle 200 H | -0.069% to 1.192% |

**[Table 6]**

| Polyimides described in Examples 1 and 2 | Short-circuit current (JSC) (mA/Cm²) | Open-circuit voltage (Voc) (V) | Fill factor (FF) | Conversion efficiency (%) |
|---|---|---|---|---|
| used | 40.922 | 0.68030 | 0.79808 | 22.2194 |

## Claims

1. A polyimide resin composition for forming an insulation film in a solar cell, said composition comprising:
a mixed solvent of a first organic solvent (A) and a second organic solvent (B); and
a heat-resistant polyimide resin having at least one group selected from the group consisting of alkyl groups and perfluoroalkyl groups in recurring units, and having thixotropic property, said polyimide resin being dissolved in said mixed solvent.

2. The composition according to claim 1, wherein each of said alkyl groups and perfluoroalkyl groups has 1 to 4 carbon atoms.

3. The composition according to claim 1 or 2, wherein said polyimide resin comprises recurring units represented by the following formula [I]: 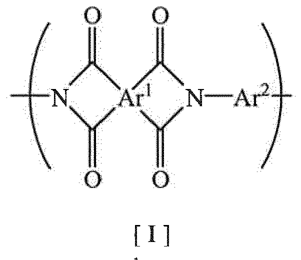 (wherein Ar¹ represents an arbitrary tetravalent organic group, Ar² represents an arbitrary divalent organic group, and at least either one of Ar¹ and Ar² have said alkyl group and/or perfluoroalkyl group).

4. The composition according to claim 3, wherein said Ar¹ is represented by the following formula [II]: 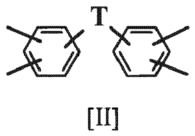 (wherein T represents -C(CH₃)₂- or -C(CF₃)₂-).

5. The composition according to claim 3 or 4, wherein said Ar² is represented by the group selected from the group consisting of the following formula [III]: 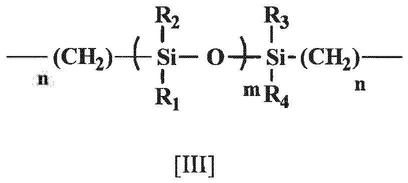 (wherein R₁, R₂, R₃ and R₄ independently represent one selected from the group consisting of hydrogen, a hydroxyl group, C₁-C₄ alkyl group, phenyl group, F, Cl and Br (wherein at least one of R₁, R₂, R₃ and R₄ represent a C₁-C₄ alkyl group), and n and m independently represent an integer of 1 to 10);
the following formula [IV]: 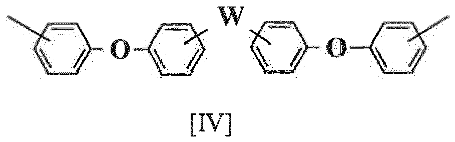 (wherein W represents -C(CH₃)₂- or -C(CF₃)₂-); and the following formula [V]: 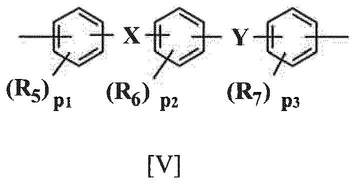 (wherein X and Y are independently selected from the group consisting of -C(=O)-, - SO₂-, -O-, -S-, -(CH₂)ₐ- (a represents an integer of 1 to 5), -NHCO-, -C(CH₃)₂-, - C(CF₃)₂-, -C(=O)O- and a single bond; R₅, R₆ and R₇ are independently selected from the group consisting of hydrogen, a hydroxyl group, C₁-C₄ alkyl group, phenyl group, F, Cl and Br (wherein at least one of R₅, R₆, and R₇ represent a C₁-C₄ alkyl group), and p1, p2 and p3 independently represent an integer of 1 to 4).

6. The composition according to any one of claims 1 to 5, wherein said polyimide resin contains 1,3-bis(3-aminopropyl)tetramethyldisiloxane in an amount of 0 to 20 mol% based on total diamine components, and has a glass transition temperature of 150°C or higher.

7. The composition according to any one of claims 1 to 6, wherein said organic solvent (A) and said organic solvent (B) have different evaporation rates, and said polyimide has a lower solubility in the organic solvent having a smaller evaporation rate.

8. The composition according to any one of claims 1 to 7, wherein said organic solvent (A) is a hydrophobic solvent and has a vapor pressure at room temperature of 1 mmHg or lower, and said organic solvent (B) is a hydrophilic solvent having a vapor pressure at room temperature of 1 mmHg or lower.

9. The composition according to any one of claims 1 to 8, which has a viscosity of 20,000 to 200,000 mPa·s at a shear rate of from 1 to 100 s⁻¹.

10. The composition according to any one of claims 1 to 9, which has a thixotropy coefficient of from 1.5 to 10.0.

11. A method of forming an insulation film in a solar cell, said method comprising coating a base layer in said solar cell with said composition according to any one of claims 1 to 10, and drying said composition to form an insulation film composed of a polyimide film.

12. The method according to claim 11, wherein said polyimide film is formed by screen printing method, ink jet method or dispense method.

13. The method according to claim 11 or 12, wherein a polyimide film having a thickness of 1 µm or more after drying is formed by one coating.

14. The method according to any one of claims 11 to 13, said method comprising:
the step of forming a first electrode by using an electrically-conductive material on a main surface of a crystalline silicon substrate composed of a single crystalline silicon or a polycrystalline silicon; and
the step of coating the surface of the first electrode with an insulation film by a printing method; and
the step of forming a second electrode on the surface of the insulation film by using an electrically-conductive material such that the second electrode is electrically insulated from the first electrode.

15. A solar cell comprising the insulation film formed by the method according to any one of claims 11 to 14.
